# EUROPÄISCHE PATENTANMELDUNG

(11) **EP 1 387 175 A1**
(43) Veröffentlichungstag der Anmeldung: **04.02.2004**
(21) Anmeldenummer: 03010445.9
(22) Anmeldetag: 09.05.2003
(51) Int. Cl.: G01R 31/08

(54) **Verfahren und Vorrichtung zum Orten von Kabelmuffen und Kabelfehlern bei verlegten Kabeln**

(30) Priorität: 30.07.2002 DE 10234537
(71) Anmelder: Hagenuk KMT Kabelmesstechnik GmbH, 04171 Radeburg (DE)
(72) Erfinder: Fraedrich, Volker, 01762 Schmiedeberg (DE)
(74) Vertreter: Hansmann, Dierk, Dipl.-Ing.

(57) **Zusammenfassung**

Bei einem Verfahren und einer Vorrichtung zum Orten von Kabelmuffen und Kabelfehlern ist vorgesehen, mittels eines an das Kabel (5) angekoppelten Tonfrequenz-Generator (1) und durch eine Verfolgung einer Kabeltrasse mit einem auf den Tonfrequenz-Generator abgestimmten Empfänger (6) mit mindestens zwei orthogonal zugeordneten Antennenspulen (17.1,17.2) einzusetzen, die eine horizontale und vertikale Richtcharakteristik aufweisen sowie durch die Orientierung ein Maximumsignal durch eine Antennenspule und ein Minimumsignal durch die andere Antennenspule aufnehmen, die einem Auswertegerät zugeführt werden. Hierbei ist vorgesehen, daß in annähernden gleichen Abständen einer Kabeltrasse die Meßwerte der Antennenspulen gemessen und einem Meßwertspeicher zugeführt werden, sowie über eine Recheneinheit beide Meßreihen der Meßwerte auf einer Anzeigeeinheit im Verhältnis zum Trassenverlauf dargestellt werden. Dabei werden über die Recheneinheit die Meßwerte jedes Meßpunktes zueinander und das Verhältnis der Meßreihen als Grad der Inhomogenität des Magnetfeldes bezogen auf jeden Meßpunkt in Form einer Kennung der Meßreihe dargestellt.

## Beschreibung

Die Erfindung bezieht sich auf ein Verfahren zum Orten von Kabelmuffen und Kabelfehlern, wie Verbindungsmuffen, Abzweigmuffen und Kabelmantelfehler, von. im Erdboden verlegten Kabeln mittels eines an das Kabel angekoppelten Tonfrequenz-Generator und durch eine Verfolgung einer Kabeltrasse mit einem auf den Tonfrequenz-Generator abgestimmten Empfänger mit mindestens zwei orthogonal zugeordneten Antennenspulen, die eine horizontale und vertikale Richtcharakteristik aufweisen sowie durch die Orientierung ein Maximumsignal durch eine Antennenspule und ein Minimumsignal durch die andere Antennenspule erzeugt wird, die einem Auswertegerät zugeführt werden.

Bei einer Ortung von Kabelmuffen und Kabelfehlern dieser Art ist es bekannt, unterschiedliche Verfahren anzuwenden.

Es ist bekannt, für die Ortung nach der sogenannten Drallfeld-Methode beide Pole eines Tonfrequenz-Generators an zwei Innenleiter am Anfang eines Kabels anzuschließen und am Ende dieses Kabels die Innenleiter miteinander zu verbinden. Diese Anordnung bewirkt im Trassenverlauf des Kabels ein resultierendes Feld, das sogenannte Drallfeld, das ein Minimum erreicht wenn beide Innenleiter horizontal nebeneinander liegen und das ein Maximum erreicht, wenn beide Innenleiter vertikal übereinander liegen.

Mit einem Empfänger, der auf die Tonfrequenz des Generators abgestimmt ist, wird der Verlauf des Kabels verfolgt. Ist der Drall der Innenleiter gleichmäßig, kann in regelmäßigen Abständen der Wechsel von Minimum und Maximum geortet werden. Wird der Drall unterbrochen, beispielsweise durch eine Kabelmuffe, ist diese Gleichmäßigkeit des Wechsels unterbrochen.

Nachteilig bei diesem Verfahren ist es, daß die Ortung des Drallfeldes nur möglich ist, wenn die Schlaglänge des Dralls der Innenleiter des Kabels ungefähr dem Abstand des Kabels zum Empfänger entspricht.

So ist beispielsweise das Drallfeld eines Mittelspannungskabels mit einer Schlaglänge des Dralls von einem Meter gut geortet werden, wenn die Verlegetiefe des Kabels ungefähr einen Meter beträgt. Das Drallfeld eines Fernmeldekabels, dessen Schlaglänge des Dralls wenige Zentimeter beträgt, kann bei einer Verlegetiefe von einem Meter nicht mehr geortet werden.

Für die ferner bekannte Ortung mit einer sogenannten Minimum-Trübung wird ein Tonfrequenz-Generator mit einem Pol an den Anfang des Kabels angeschlossen und der andere Pol mit der Erde verbunden. Das Ende des Kabels wird ebenfalls mit der Erde verbunden, so daß ein Stromkreis für das Tonfrequenz-Signal mit der Rückleitung durch die Erde geschlossen ist.

Mit einem Empfänger, der auf die Tonfrequenz des Generators abgestimmt ist, wird der Verlauf des Kabels nach der traditionellen Minimum-Methode verfolgt. Über der Kabeltrasse bildet sich ein homogenes Magnetfeld aus, daß im Empfänger ein sehr scharfes Minimum erzeugt. Im Bereich einer Kabelmuffe oder eines Kabelfehlers wird die Homogenität des Magnetfeldes verzerrt und es ist erkennbar, daß die Schärfe des Minimums verringert erscheint.

Der Mangel bei diesem Verfahren ist es, daß die Beurteilung der Minimum-Trübung sehr subjektiv ist und vom Bedienpersonal des Empfängers vergleichsweise viel Erfahrung und physikalisch-technische Qualifikationen erfordert.

Eine Verbesserung für die Ortung von Kabelfehlern mit einer Minimum-Trübung ist nach der US-PS 5,714,885 bekannt geworden. Es ist hierbei vorgesehen, daß der Tonfrequenz-Generator eine Kombination von zwei Frequenzen an das zu untersuchende Kabel koppelt. Der Empfänger ortet über Antennenspulen das magnetische Feld und über in den Erdboden gestoßene Spitzen das elektrische Feld. Durch die Bewertung dieser unterschiedlichen Feldkomponenten bei zwei unterschiedlichen Frequenzen kann eine deutlich verbesserte Ortung mit dem Empfänger erreicht werden.

Bei diesem Verfahren ist der vergleichsweise hohe apparative Aufwand für die Erzeugung der Frequenzen im Generator und die Bewertung aller Signalkomponenten im Empfänger relativ aufwendig.

Ein weiteres Verfahren zur Ortung von Kabelfehlern ist aus der DE-PS 19824157 zu entnehmen. Hierbei erzeugt ein Generator zwei mit Tonfrequenz modulierte Hochfrequenzsignale, die in das Kabel eingekoppelt werden. Ein Empfänger bewertet diese Signale und bringt durch unterschiedliche Tonausgaben den Fehler zur Anzeige.

Nachteilig bei diesem Verfahren ist es, daß durch die Anwendung von Hochfrequenzsignalen die Reichweite vergleichsweise gering ist und daß die Anwendung lediglich für geschirmte Kabel, beispielsweise Koaxialkabel, möglich ist. Verdeckt verlegte Kabelmuffen können mit diesem Verfahren nicht geortet werden.

Ferner ist ein weiteres Verfahren zur Ortung von Kabelfehlern, insbesondere zur Ortung metallisch blanker Isolierfehler bei Erdkabeln und Rohrleitungen gemäß der US-PS 5,828,219 bekannt. Ein Generator speist dabei ein sehr niederfrequentes Signal <10 Hz und ein Tonfrequenzsignal >100 Hz in die Leitung ein. Der Empfänger enthält eine Kombination von Magnetometer und Antennenspulen. Diese Kombination wird genutzt um die Verlegetiefe und die Stromstärke punktweise über der Leitungstrasse aufzunehmen. Die Bewertung des Gradienten zwischen den vorliegenden Meßwerten für die Stromstärke führt zu Ortung des Fehlers.

Bei diesem Verfahren besteht die Notwendigkeit, den Generator stets direkt galvanisch an die Leitung anzuschließen, um eine niedrige Frequenz wirksam anzukoppeln. Der hierbei erforderliche hohe apparative Aufwand beim Empfänger, bedingt durch die Kombination von Magnetometer und konventioneller Antennenspulen ist dabei nachteilig. Verdeckt verlegte Kabelmuffen können mit diesem Verfahren nicht geortet werden.

Alle bekannten Verfahren und Vorrichtungen der diskutierten Art haben den Mangel, daß hohe Anforderungen hinsichtlich des apparativen Aufwandes besteht oder aber die Beurteilung des komplexen Empfangssignals sehr subjektiv ist und vom Bedienpersonal des Empfängers vergleichsweise viel Erfahrung und physikalisch-technische Qualifikation erfordert.

Die Aufgabe der Erfindung ist es, ein Verfahren und eine Vorrichtung für die Ortung der gattungsgemäßen Art zu schaffen, die auf einfache Weise mit relativ geringeren apparativem Aufwand eine eindeutige Darstellung von Kabelmuffen und Kabelfehler ermöglicht und eine Auswertung ohne hohe Qualifikation des Bedienpersonals gewährleistet.

Die Lösung dieser Aufgabe erfolgt durch folgende Verfahrensschnitte dadurch, daß in annähernden gleichen Abständen einer Kabeltrasse die Meßwerte der Antennenspulen gemessen und einem Meßwertspeicher zugeführt werden, sowie über eine Recheneinheit beide Meßreihen der Meßwerte auf einer Anzeigeeinheit im Verhältnis zum Trassenverlauf dargestellt, wobei über die Recheneinheit die Meßwerte jedes Meßpunktes zueinander und das Verhältnis der Meßreihen als Grad der Inhomogenität des Magnetfeldes bezogen auf jeden Meßpunkt in Form einer Kennung (Linienverdickung, Farbkennzeichnung, Muster) der Meßreihe dargestellt wird.

Hierdurch ist es möglich, daß aus der Bewertung der einzelnen Meßwerte einer Meßwert-Gruppe sowie die Kontinuität der einzelnen Meßwerte innerhalb der gesamten Meßreihe Rückschlüsse auf die Homogenität des Magnetfeldes gezogen werden können. Die im Bereich einer Kabelmuffe oder eines Kabelfehlers meßbare Inhomogenität wird im Verlauf des Liniendiagramms eindeutig gekennzeichnet.

Die Vorteile der Lösung ergeben sich auch durch die Verwendung eines traditionellen Tonfrequenz-Generators, der nicht an eine einzelne Festfrequenz oder eine festgelegte Kombination von Frequenzen gebunden ist oder der über besondere Mittel zur Modulation verfügen muß. Durch die Wahl der Grundfrequenz des Generator-Signals entsprechend dem Typ der zu ortenden Leitung mit ihren speziellen komplexen elektrischen Parametern ist eine einfache Anpassung des Verfahrens bzw. der Vorrichtung möglich. So ergeben sich Vorteile, wenn für lange Leitungen mit großem Durchmesser die Grundfrequenz relativ klein, jedoch in verzweigten Netzen mit kurzen Kabeln die Grundfrequenz relativ hoch ist.

Da das Verfahren einzig auf die Bewertung von Feldstärkemessungen beruht und bei der folgenden Signalverarbeitung weder Modulation noch Phasenbewertung vorgenommen wird, ist das Meßergebnis weitgehend unabhängig von der Frequenz. Der analoge Schaltungsteil des Empfängers kann somit besonders kostengünstig nach konventionellen Prinzipien aufgebaut sein.

Ein signifikanter Vorteil besteht in der unmittelbaren Darstellung der Meßergebnisse als Liniendiagramm auf einem Display am Empfänger, wobei durch die Bildung einer Meßreihe aus mehreren Meßwerten und deren mathematische Bewertung eine eindeutige Kennzeichnung von Inhomogenitäten des Magnetfeldes im Verlauf des Liniendiagramms erfolgt und eine einfache und schnelle Ortung von Kabelmuffen und Kabelfehlern ermöglicht. Zur Optimierung des Ortungsergebnisses kann erneut eine Meßreihe aufgenommen werden, beispielsweise mit verändertem Abstand der Meßpunkte über der Kabeltrasse.

Ein zusätzlicher Vorteil ist gegeben, wenn eine Bewertung des Grades der Inhomogenität des Magnetfeldes vorgenommen wird und das Ergebnis direkt aus der Kennzeichnung im Liniendiagramm ablesbar ist, beispielsweise durch unterschiedliche Strichstärken der Linie des Diagramms.

Eine vorteilhafte Weiterbildung besteht darin, daß die Meßreihe mit einem Geo-Informations-System der Trassenführung überlagerbar ist.

Eine Vorrichtung zur Durchführung des Verfahrens besteht darin, daß ein Empfänger, in Zuordnung zum Kabel mit einem gekoppelten Tonfrequenz-Generators, zur Aufnahme der Empfangssignale der Antennenspulen für die horizontale und vertikale Richtcharakteristik jeweils getrennt zugeordnete Verstärker aufweisen und über einen Analog-Digital-Wandler einer Recheneinheit zur Bestimmung der Empfangssignalstärke zuführbar sind und in annähernd gleichen Abständen der Kabeltrasse die Meßwert-Gruppen über einen Schalter am Empfänger einem Speicher zuführbar sind und die gespeicherten Meßwertgruppen durch die Recheneinheit über einen Schalter die erfaßten Meßwertgruppen in der Reihenfolge der einzelnen Meßwerte jedes Meßpunktes zueinander und das Verhältnis der Meßreihen als Grad der Inhomogenität des Magnetfeldes bezogen auf jeden Meßpunkt in Form einer Kennung der Meßbereiche über ein Display des Empfängers mit einem Trassenverlauf darstellbar ist.

Ferner ist vorgesehen, daß der Schalter durch einen zeitgesteuerten Geber gebildet ist.

In der Zeichnung ist ein Ausführungsbeispiel der Erfindung schematisch dargestellt. Es zeigen:
- Fig. 1: eine prinzipielle Gesamtdarstellung einer Anordnung;
- Fig. 2: ein Blockschaltplan eines Empfängers;
- Fig. 3: ein Liniendiagramm der aufgenommenen Meßpunkte mit der Darstellung der Meßwerte einer Meßreihe ohne Bewertung des Grades der Inhomogenität des Magnetfeldes;
- Fig. 4: ein Liniendiagramm mit der errechneten Darstellung der Meßwerte einer Meßreihe mit der Kennzeichnung des Grades der Inhomogenität des Magnetfeldes;
und
- Fig. 5: ein Liniendiagramm gemäß Fig. 4 mit der Kennzeichnung eines unterschiedlichen Grades der Inhomogenität über einer Abzweigmuffe und über einer Verbindungsmuffe

Aus dem dargestellten Gesamtaufbau ist ersichtlich, daß ein Tonfrequenz-Generator 1 mit einem ersten Pol 3 an einen Innenleiter 4 am Anfang eines Kabels 5 und mit einem zweiten Pol 13 an einen Erdungspunkt 14 angeschlossen ist. Am Ende des Kabels 5 ist der Innenleiter 4 am Punkt 11 mit einem weiteren Erdungspunkt 12 verbunden.

Der Stromkreis für das Tonfrequenz-Signal des Tonfrequenz-Generators 1 ist somit über die Erdverbindung geschlossen. Ein Empfänger 6 enthält mindestens zwei Antennenspulen, eine erste Antennenspule 17.1 mit horizontaler Richtcharakteristik und eine zweite Antennenspule 17.2 mit vertikaler Richtcharakteristik, beide Spulen sind orthogonal zueinander angeordnet. Mit einem Empfänger 6 wird das durch den Signalstrom des Generators 1 erzeugte Magnetfeld 9 über der Trasse des Kabels 5 aufgenommen. Der Empfänger wird dabei so orientiert, daß in bekannter Weise eine erste Antennenspule 17.1 ein Maximum-Signal und eine zweite Antennenspule 17.2 ein Minimum-Signal erzeugt.

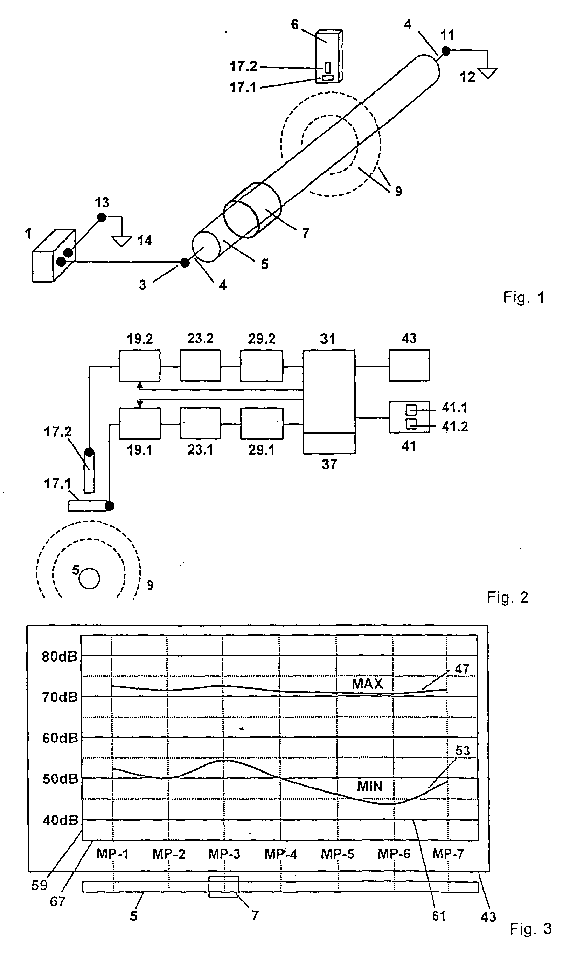

Gemäß einem. Blockschaltplan des Empfängers 6 nach Fig. 2 wird ein das Kabel 5 umschließende Magnetfeld 9 mit der Antennenspulen 17.1 empfangen. Das Empfangssignal wird einem von einem Rechner 31 steuerbaren, vorzugsweise logarithmierendem Verstärker 19.1 zugeführt, passiert ein auf die Signalfrequenz des Generators 1 abgestimmtes Filter 23.1 und gelangt an den Eingang eines Anolog-Digital-Wandlers 29.1.

Ein zweiter, vorzugsweise identisch dimensionierter Schaltungsteil besteht aus der Antennenspule 17.2, einem Verstärker 19.2, einem Filter 23.2 und einem Analog-Digital-Wandler 29.2.

Die Verstärker 19.1 und 19.2 können unabhängig voneinander eingestellt werden. Die optimale Verstärkung wird jeweils der Empfangssignalstärke an den Antennenspulen 17.1 und 17.2 durch einen Algorithmus im Rechner 31 angepaßt.

Die digitalisierten Werte an den Ausgängen der Analog-Digital-Wandler 29.1 und 29.2 werden vom Rechner 31 eingelesen, in Abhängigkeit von der Stellung der Verstärker 19.1 und 19.2 in zwei getrennte Meßwerte als Maß für die Empfangssignalstärke umgerechnet und am Empfänger 6 nach Wahl des Bedienpersonals akustisch oder optisch zur Anzeige gebracht.

Durch eine Betätigung einer Taste 41.1 eines Tastenfeldes 41 am Empfänger 6 veranlaßt im Rechner 31 die Zusammenfassung der zuletzt berechneten Meßwerte zu einer Meßwert-Gruppe und die Ablage dieser Meßwert-Gruppe in einem integrierten Speicher 37. Jede Meßwert-Gruppe erhält zur eindeutigen Identifikation eine Meßwert-Nummer, beispielsweise eine fortlaufende Zahl oder einen Zeitstempel eines integrierten Zeitgebers.

Eine Meßreihe wird dabei aus mehreren nacheinander aufgenommenen Meßwert-Gruppen gebildet, wobei das Bedienpersonal des Empfängers 6 die Trasse des Kabels 5 verfolgt und an Meßpunkten MP-1 bis MP-7 mit annähernd gleich großen Abständen mit der Taste 41.1 die Speicherung der Meßwert-Gruppe auslöst.

Die Betätigung einer Taste 41.2 des Tastenfeldes 41 am Empfänger 6 veranlaßt im Rechner 31 die Zusammenfassung der gespeicherten Meßwert-Gruppen in der Reihenfolge ihrer Meßwert-Nummern zu einer Meßreihe und die Berechnung der Daten für die Anzeige eines Liniendiagramms 61 auf dem grafischen Display 43, integriert im Empfänger 6.

Im Diagramm gemäß Fig. 3 ist das Kabel 5 mit der Kabelmuffe 7 und das den Meßpunkten MP-1 bis MP-7 zugeordnete Liniendiagramm 61 mit der Darstellung der Meßwerte 47 und 53 einer Meßreihe ohne Bewertung des Grades der Inhomogenität des Magnetfeldes dargestellt.

Die Teilung und Beschriftung der Achsen des Liniendiagramms 61 erfolgt zweckmäßigerweise mit der Angabe der Meßpunkte MP-1 bis MP-7 auf der X-Achse 67 und der Angabe der Empfangssignalstärke auf der Y-Achse 59.

Die Meßwerte der Antennenspule 17.1 bilden den Verlauf des Maximum-Signals MAX entlang der Kabeltrasse ab und sind als Graf 47 im Liniendiagramm 61 dargestellt, die Meßwerte der Antennenspule 17.2 bilden den Verlauf des Minimum-Signals MIN entlang der Kabeltrasse ab und sind als Graf 53 dargestellt.

Zur Wandlung dieser Daten wird im Rechner 31 eine Bewertung der Meßwerte vorgenommen, wobei das Verhältnis der Meßwerte eines Meßpunktes zueinander und das Verhältnis der Meßwerte der gesamten Meßreihe abgeglichen wird.

Das Ergebnis dieser Untersuchung ist eine Maßzahl für den Grad der Inhomogenität des Magnetfeldes, bezogen auf jeden Meßpunkt. Diese Maßzahl ist eine intern normierte Größe und gibt direkt einen Multiplikator für die Strichstärke der Linie im Diagramm an.

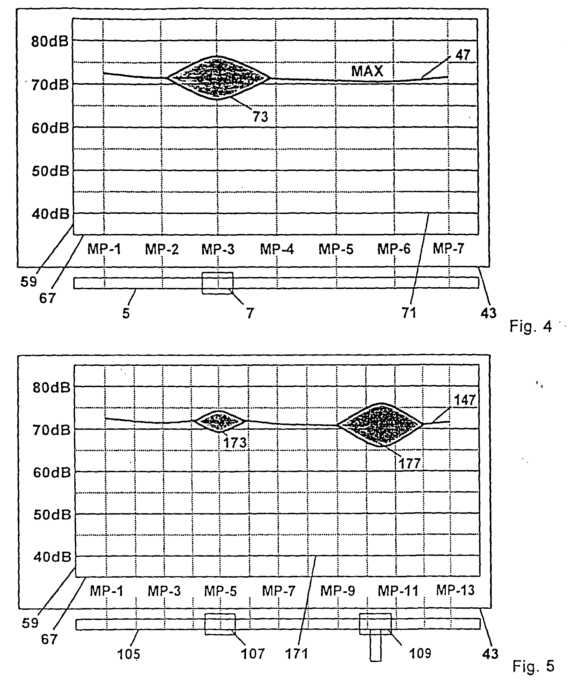

Fig. 4 zeigt das Kabel 5 mit der Kabelmuffe 7 und das den Meßpunkten zugeordnete Liniendiagramm 71 mit der Darstellung der Meßwerte der Meßreihe 47 des Maximum-Signals MAX mit der Kennzeichnung 73 des Grades der Inhomogenität des Magnetfeldes. Deutlich nach der Auswertung wird dabei die Lage der Kabelmuffe 7 im Verlauf der Trasse des Kabels 5 erkennbar.

Beispielhaft ist in Fig. 5 ein Ausführungsbeispiel mit einem Kabel 105 mit einer Verbindungsmuffe 107 und einer Abzweigmuffe 109 und ein den Meßpunkten MP-1 bis MP-13 zugeordnetes Liniendiagramm 171 mit der Darstellung einer Meßreihe 147 mit der Kennzeichnung unterschiedlichen Grades der Inhomogenität 173 und 177 über der Verbindungsmuffe 107 und über der Abzweigmuffe 109 gezeigt. Es ist dabei erkennbar, daß die Abzweigmuffe 109 einen stärkeren Grad der Inhomogenität des Magnetfeldes (Feldverzerrung) bewirkt als die Verbindungsmuffe 107.

Eine vorteilhafte Weiterbildung ist selbstverständlich möglich, wenn der Empfänger 6 weitere Mittel zur Messung der Verlegetiefe und der Stromstärke enthält. Diese Meßwerte werden dann der Meßwert-Gruppe am Meßpunkt zugeordnet und anschließend als Meßreihe im Liniendiagramm mit der Maßzahl für die Strichstärke der Linie beaufschlagt.

## Patentansprüche

1. Verfahren zum Orten von Kabelmuffen und Kabelfehlern, wie Verbindungsmuffen, Abzweigmuffen und Kabelmantelfehler, von im Erdboden verlegten Kabeln mittels eines an das Kabel angekoppelten Tonfrequenz-Generator und durch eine Verfolgung einer Kabeltrasse mit einem auf den Tonfrequenz-Generator abgestimmten Empfänger mit mindestens zwei orthogonal zugeordneten Antennenspulen, die eine horizontale und vertikale Richtcharakteristik aufweisen sowie durch die Orientierung ein Maximumsignal durch eine Antennenspule und ein Minimumsignal durch die andere Antennenspule erzeugt wird, die einem Auswertegerät zugeführt werden, **dadurch gekennzeichnet, daß** in annähernden gleichen Abständen einer Kabeltrasse die Meßwerte der Antennenspulen gemessen und einem Meßwertspeicher zugeführt werden, sowie über eine Recheneinheit beide Meßreihen der Meßwerte auf einer Anzeigeeinheit im Verhältnis zum Trassenverlauf dargestellt, wobei über die Recheneinheit die Meßwerte jedes Meßpunktes zueinander und das Verhältnis der Meßreihen als Grad der Inhomogenität des Magnetfeldes bezogen auf jeden Meßpunkt in Form einer Kennung (Linienverdickung, Farbkennzeichnung, Muster) der Meßreihe dargestellt wird.

2. Verfahren nach Anspruch 1, **dadurch gekennzeichnet, daß** die Meßreihe mit einem Geo-Informations-System der Trassenführung überlagerbar ist.

3. Vorrichtung zur Durchführung des Verfahrens nach Anspruch 1, **dadurch gekennzeichnet, daß** ein Empfänger (6), in Zuordnung zum Kabel (5) mit einem gekoppelten Tonfrequenz-Generators (1), zur Aufnahme der Empfangssignale der Antennenspulen (17.1, 17.2) für die horizontale und vertikale Richtcharakteristik jeweils getrennt zugeordnete Verstärker (19.1, 19.2) aufweisen und über einen Analog-Digital-Wandler (29.1, 29.2) einer Recheneinheit (31) zur Bestimmung der Empfangssignalstärke zuführbar sind und in annähernd gleichen Abständen der Kabeltrasse die Meßwert-Gruppen über einen Schalter (41.1) am Empfänger (6) einem Speicher (37) zuführbar sind und die gespeicherten Meßwertgruppen durch die Recheneinheit (31) über einen Schalter (41.2) die erfaßten Meßwertgruppen in der Reihenfolge der einzelnen Meßwerte jedes Meßpunktes zueinander und das Verhältnis der Meßreihen als Grad der Inhomogenität des Magnetfeldes bezogen auf jeden Meßpunkt in Form einer Kennung (76) der Meßbereiche über ein Display (43) des Empfängers (6) mit einem Trassenverlauf darstellbar ist.

4. Vorrichtung nach Anspruch 3, **dadurch gekennzeichnet, daß** der Schalter (41.2) durch einen zeitgesteuerten Geber gebildet ist.
